# EUROPEAN PATENT APPLICATION

(11) **EP 2 690 813 A1**
(43) Date of publication of application: **29.01.2014**
(21) Application number: 12178274.2
(22) Date of filing: 27.07.2012
(51) Int. Cl.: H04L 1/00, H03M 13/27

(54) **Transparent component interleaving for rotated constellations**

(71) Applicant: Panasonic Corporation, Osaka 571-8501 (JP)
(72) Inventor: Petrov, Mihail, 63225 Langen (DE)
(74) Representative: Grünecker, Kinkeldey, Stockmair & Schwanhäusser

(57) **Abstract**

The present invention relates to communication systems that employ rotated constellations and provides a transmitter in which a component interleaver is paired with a matching deinterleaver upstream of the constellation rotation, as well as corresponding receivers and methods. According to this configuration, component separation can be performed while preserving the cell order.

## Description

### TECHNICAL FIELD

The present invention relates to the field of digital communications and more specifically to communication systems that employ rotated constellations.

### BACKGROUND OF THE INVENTION

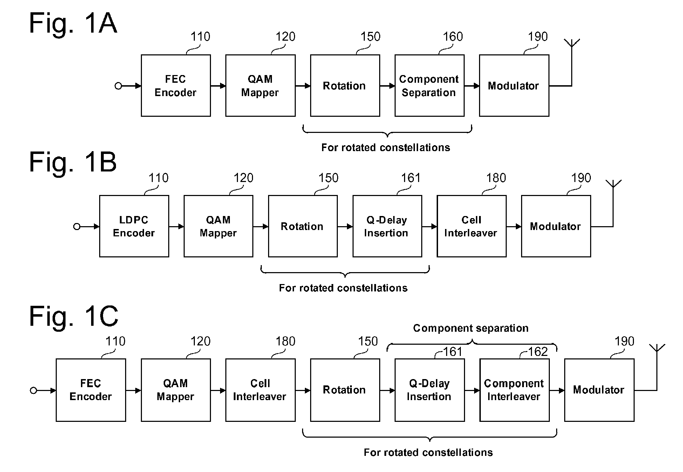

Figure 1 shows a block diagram of a generic transmitter that employs rotated constellations. The diagram is simplified to include only blocks that are relevant to the present invention.

The transmitter receives at its input binary blocks of a predetermined length, containing the information to be transmitted. Each information block is first encoded by an FEC (forward error correction) encoder, the encoding process consisting in computing and adding redundancy bits in order to make the reception of the information block more robust against errors.

The bits of the encoded FEC codeword, thereafter referred to as FEC block, are optionally interleaved using a bit interleaver (not shown) and mapped onto complex QAM symbols.

The real and imaginary components of the QAM symbols are modulated independently, each component encoding a predefined number of bits, denoted here by B. These two components can be regarded as PAM (pulse amplitude modulation) or ASK (amplitude shift keying) symbols, such a symbol taking a value from a discrete set of 2*^{B}* values. How the B bits are mapped to PAM symbols is well known in the art. As a result of the mapping process, each FEC block is transformed into a block of complex QAM symbols.

The complex QAM symbols produced by the QAM mapper are then rotated in order to introduce a dependence between the real and the imaginary components, which increases the robustness in fading channels. These components can be regarded as identifying unique points in a two-dimensional space, the resulting 2^{2*B*} combinations forming a two-dimensional constellation. The rotation consists in multiplying the vector of the two real components by an orthogonal 2x2 rotation matrix, hence the term rotated constellations.

The same principle can be extended to more than two dimensions. The number of dimensions is hereafter denoted by *D*. In this case, *D* PAM symbols can be jointly encoded by multiplying the vector of *D* real symbols by a *DxD* generalized rotation matrix. The particular structure of the rotation matrix is not relevant to the present invention.

After the rotation step, the *D* real components undergo a further processing step whereby the *D* components of each constellation are mapped to *D* different complex symbols (also referred to as cells). In order to achieve good performance with rotated constellations, the *D* complex symbols are preferably spread as far as possible in time and frequency, so that the channel fading they experience is as uncorrelated as possible. These aspects are generally well understood. In Figure 1A this function is performed by the generic component-separation block 160.

Finally, the complex QAM symbols are modulated and transmitted over the communication medium. According to the DVB-T2 standard, for example, the modulation scheme is OFDM (orthogonal frequency-division multiplexing) and additional steps of time and frequency interleaving may be performed prior to the modulation in order to increase the diversity of the system.

There are solutions for component separation known in the art. The first solution is the rotated-constellation scheme specified by the DVB-T2 standard. The second solution is an improvement thereof adopted for the upcoming DVB-NGH standard (next-generation handheld, ETSI EN 303 105, provisional name).

DVB-T2 (Digital Video Broadcasting - Second Generation Terrestrial) (ETSI EN 302.755) is an improvement of the television standard DVB-T and describes a second generation transmission system for digital terrestrial television broadcasting. It specifies the channel coding/modulation system intended for digital television services and generic data. Figure 1B shows a transmitter block diagram according to the DVB-T2 standard. The figure contains only those blocks relevant to the present invention. In DVB-T2 the FEC code is an LDPC (low-density parity-check) code and only rotated constellations in two dimensional are supported.

The separation of the *D* components is achieved by delaying the imaginary (or quadrature, hence the name Q-delay) components by *D*/2 cells and applying a cell interleaving to the resulting cells. In DVB-T2 the cell permutation is a pseudo-random permutation generated with an LFSR (linear feedback shift register). Moreover, a different permutation is used for each FEC block in order to improve the randomization.

The cell interleaver in DVB-T2 performs two distinct functions.

The first function is to spread the burst errors that occur in the channel as irregularly as possible throughout an FEC block. This function is performed reasonably well by the pseudo-random cell interleaver in DVB-T2 and is applicable to both rotated and non-rotated constellations.

The second function is to spread the rotated-constellation components optimally over the FEC block. This function is relevant only for rotated constellations. Unfortunately, a pseudo-random cell interleaving like in DVB-T2 achieves a sub-optimal separation of the constellation components in time and frequency, which results in sub-optimal performance in fading or erasure channels.

An improved separation of the components can be obtained by replacing the pseudo-random cell interleaver in DVB-T2 with an interleaver that is specifically optimized for achieving an optimal component separation. However, this interleaver has a regular structure, which makes it sub-optimal with respect to the first function.

In order to simultaneously optimize the interleaver with respect to both functions, it has been suggested to separate the two functions by implementing them in two dedicated blocks (the cell interleaver 180 and the component interleaver 162). This approach, which allows each block to be optimized for its respective function, is illustrated in Figure 1C. The component interleaver (162) in conjunction with the Q-delay insertion (161) perform the generic component separation function (160) of Figure 1A.

### SUMMARY OF THE INVENTION

The inventor has realized that the resilience of communication systems that employ rotated constellations to burst errors can be improved by employing a cell interleaver with a regular structure instead of a pseudo-random one. However, when the cell interleaver has a regular structure, its optimality is affected by the subsequent component separation for rotated constellations. This problem does not exist with a pseudo-random interleaver since the combined interleaver is still pseudo random.

It is therefore the object of the present invention to provide a solution that preserves the optimality of the cell interleaver, while still ensuring an optimal component separation for rotated constellations.

This is achieved by the features as set forth in the independent claims.

Preferred embodiments are the subject matter of dependent claims.

It is the particular approach of the present invention to perform component separation without changing the order of the cells. In this manner, the optimality of the cell interleaver is preserved.

According to a first aspect of the present invention, a method for transmitting digital data is provided. The method comprises the steps of encoding a block of data with a forward error correction code; mapping the encoded block of data to a sequence of real-valued symbols; applying a first symbol permutation to the sequence of real-valued symbols; dividing the permuted sequence of real-valued symbols into a plurality of D-dimensional vectors and transforming each of the D-dimensional vectors by multiplying the vector with an orthogonal matrix, resulting in a sequence of transformed symbols; applying a second symbol permutation to the sequence of transformed symbols, wherein the first symbol permutation is an inverse of the second symbol permutation; mapping the transformed symbols of the permuted sequence of transformed symbols to a sequence of complex symbols; and transmitting the sequence of complex symbols.

According to a further aspect of the present invention, an apparatus for transmitting digital data is provided. The apparatus comprises an encoder for encoding a block of data with a forward error correction code; a mapper for mapping the encoded block of data to a sequence of real-valued symbols; a component deinterleaver for applying a first symbol permutation to the sequence of real-valued symbols; a rotation unit for dividing the permuted sequence of real-valued symbols into a plurality of D-dimensional vectors and transforming each of the D-dimensional vectors by multiplying the vector with an orthogonal matrix, resulting in a sequence of transformed symbols; a component interleaver for applying a second symbol permutation to the sequence of transformed symbols, wherein the first symbol permutation is an inverse of the second symbol permutation; a cell interleaver for mapping the transformed symbols of the permuted sequence of transformed symbols to a sequence of complex symbols; and a modulator for transmitting the sequence of complex symbols.

According to a further aspect of the present invention, a method for receiving digital data is provided. The method comprises the steps of receiving a sequence of complex symbols; mapping the a sequence of complex symbols to a sequence of real-valued symbols; applying a first symbol permutation to the sequence of real-valued symbols; dividing the permuted sequence of real-valued symbols into a plurality of D-dimensional vectors and transforming each of the D-dimensional vectors by multiplying the vector with an orthogonal matrix, resulting in a sequence of transformed symbols; applying a second symbol permutation to the sequence of transformed symbols, wherein the first symbol permutation is an inverse of the second symbol permutation; de-mapping the sequence of real-valued symbols to an encoded block of data; and decoding the encoded block of data with a forward error correction code.

According to a further aspect of the present invention, an apparatus for receiving digital data is provided. The apparatus comprises a demodulator for receiving a sequence of complex symbols; a cell deinterleaver for mapping the sequence of complex symbols to a sequence of real-valued symbols; a component deinterleaver for applying a first symbol permutation to the sequence of real-valued symbols; a de-rotation unit for dividing the permuted sequence of real-valued symbols into a plurality of D-dimensional vectors and for transforming each of the D-dimensional vectors by multiplying the vector with an orthogonal matrix, resulting in a sequence of transformed symbols; a component interleaver for applying a second symbol permutation to the sequence of transformed symbols, wherein the first symbol permutation is an inverse of the second symbol permutation; a de-mapper for de-mapping the sequence of real-valued symbols to an encoded block of data; and a decoder for decoding the encoded block of data with a forward error correction code.

Preferably, the second symbol permutation is adapted such that the D real-valued symbols of each transformed vector are mapped to D distinct complex symbols of the sequence of complex symbols. Further, the second symbol permutation may be adapted such that the D real-valued symbols of each transformed vector are essentially evenly distributed over the sequence of transformed symbols. In this manner, the resilience of the communication system to burst errors can be improved.

Preferably, the forward error correction code is a turbo code, a low-density parity-check code or a quasi-cyclic low-density parity-check code.

The dimension D of the rotated constellations is preferably 2 or 4. However, the present invention is also applicable to any other dimension, such as 8 or more.

The mapping of the transformed symbols of the permuted sequence of transformed symbols to the sequence of complex symbols is preferably performed by mapping two consecutive transformed symbols of the permuted sequence of transformed symbols to one complex symbol of the sequence of complex symbols. Moreover, a cell permutation may be applied to the sequence of complex symbols. This form of cell interleaving further increases the resilience of the communication system to burst errors.

The mapping of the encoded block of data to the sequence of real-valued symbols may be performed in accordance with a pulse amplitude modulation scheme or an amplitude shift keying scheme.

The mapping (120) of the encoded block of data to the sequence of real-valued symbols may preferably be performed such that B consecutive bits of the encoded block of data are mapped to one real-valued symbol of the sequence of real-valued symbols, B being a positive integer, preferably B=1, 2, 3, or 4. In this manner, a 4-QAM, 8-QAM, or 16-QAM coding scheme may be employed. However, the present invention is also applicable to other coding schemes such as 64-QAM, 128-QAM, and so on.

The above and other objects and features of the present invention will become more apparent from the following description and preferred embodiments given in conjunction with the accompanying drawings, in which:
- Fig. 1A: shows a block diagram of a generic transmitter for rotated constellations;
- Fig. 1B: shows a block diagram of a conventional transmitter structure according to DVB-T2;
- Fig. 1C: shows a block diagram of a conventional transmitter structure according to DVB-NGH;
- Fig. 2A: is a schematic diagram illustrating a first approach for mapping D constellation components to D adjacent symbols;
- Fig. 2B: is a schematic diagram illustrating a second approach for mapping D constellation components to D adjacent symbols;
- Fig. 3A: shows a block diagram of a transmitter for rotated constellations according to a first embodiment of the present invention;
- Fig. 3B: shows a block diagram of a transmitter for rotated constellations according to a second embodiment of the present invention;
- Fig. 3C: shows a block diagram of a transmitter for rotated constellations according to a third embodiment of the present invention;
- Fig. 3D: shows a block diagram of a transmitter for rotated constellations according to a fourth embodiment of the present invention;
- Fig. 4A: shows a block diagram of a receiver for rotated constellations according to a first embodiment of the present invention;
- Fig. 4B: shows a block diagram of a receiver for rotated constellations according to a second embodiment of the present invention;
- Fig. 4C: shows a block diagram of a receiver for rotated constellations according to a third embodiment of the present invention; and
- Fig. 4D: shows a block diagram of a receiver for rotated constellations according to a fourth embodiment of the present invention.

### DETAILED DESCRIPTION

In order to better understand the present invention, a few explanations regarding the component separation are in order. Typically, component separation is performed by applying a permutation to the real and imaginary components of the cells of an FEC block. Two approaches are possible.

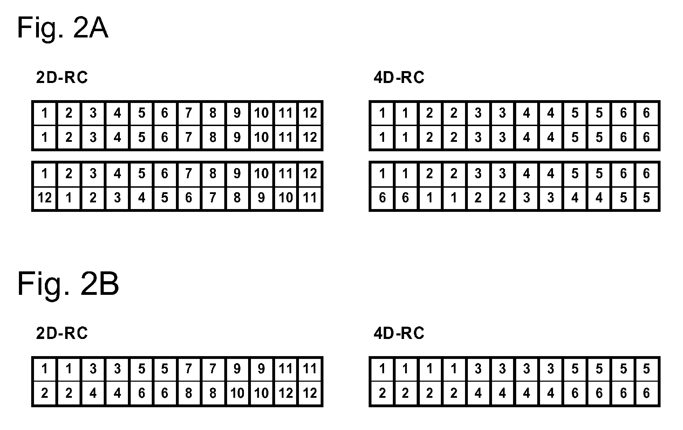

The first approach comprises the steps of: 1) applying the constellation rotation to the D real components of D/2 adjacent cells, 2) applying a relative delay of at least D/2 cells between the real and the imaginary components so that the D components of each rotated constellation block end up in different cells, and 3) applying the same block permutation to the real and imaginary components of the resulting cells. The first two steps are illustrated in Figure 2A for D=2 and D=4, with a relative delay of D/2. Here the squares represent constellation components, the columns represent complex cells, each with a real and an imaginary component, and the square indices indicate the constellation block to which the corresponding component belongs.

Such an approach is used in DVB-T2 and DVB-NGH, and is shown in Figure 1 B and Figure 1C, respectively. The component separation (as in the generic Figure 1A) is performed in the combined steps 2 and 3 and is equivalent to applying different block permutations to the real and the imaginary components, since the relative delay can be regarded as a permutation. For the purpose of the present invention we extend the definition of the component interleaver to include the Q-delay as well, i.e. the terms component interleaving and component separation are used interchangeably.

The second approach comprises the steps of: 1) applying a first constellation rotation to D real or imaginary components of D adjacent complex symbols, and applying a second rotation to the remaining D components of said D symbols, then 2) applying the same block permutation to the real and imaginary components of the resulting complex symbols. This second step is identical to the third step in the first approach. Preferably, the two constellation rotations in the first step are applied only the real and the imaginary components of D adjacent complex symbols, respectively. Figure 2B illustrates this for D=2 and D=4.

To summarize, the two approaches are similar in that they both consist of a constellation rotation followed by a component interleaver. In the first approach the interleaver permutation is different for the real and the imaginary components, whereas in the second approach the permutations are identical.

It is the particular approach of the present invention to pair the component interleaver with a matching deinterleaver upstream of the constellation rotation in order to preserve the cell order. The resulting structure is therefore transparent for the symbols produced by the cell interleaver and the optimality of the latter is not affected. Moreover, constellation rotation may be applied to non-adjacent components within the FEC block.

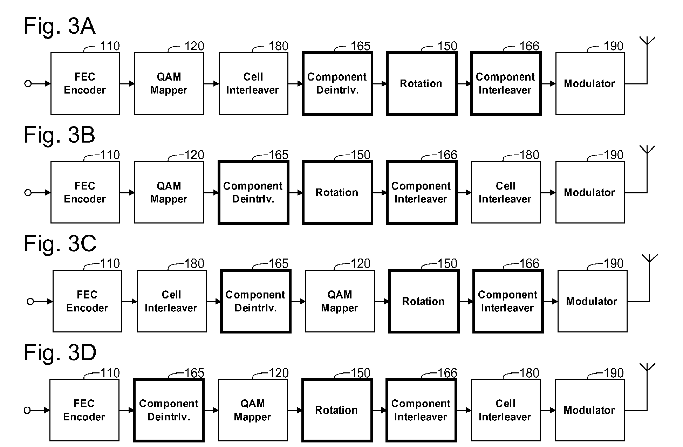

Fig. 3A shows a block diagram of a transmitter for rotated constellations according to a first embodiment of the present invention. The block diagram is similar to the generic diagram of Fig. 1C, wherein like reference numerals denote like components, a repetition of the detailed explanation of which is omitted. Blocks used for rotated constellations only are shown with bold border lines. Fig. 3A differs from Fig. 1C in that component separation blocks 161, 162 are replaced by component interleaver and deinterleaver blocks 165, 166.

As it is apparent from Fig. 3A, the block for performing constellation rotation (150) is bracketed with a matched pair of a component deinterleaver 165 and component interleaver 166. The permutation performed by component deinterleaver 165 reverts the permutation performed by component interleaver 166 so that cell order is not affected. In other words, the permutation performed by component deinterleaver 165 is the inverse of the permutation performed by component interleaver 166 and vice versa.

Fig. 3B shows a block diagram of a transmitter for rotated constellations according to a second embodiment of the present invention. The block diagram is similar to the block diagram of Fig. 3A, wherein like reference numerals denote like components, a repetition of the detailed explanation of which is omitted.

As it is apparent from Fig. 3B, the cell interleaver 180 is located downstream of the component interleaver 166. In order to keep the original functionality unchanged, the component-interleaver 166 would have a new permutation which would be given by the concatenation of the old permutation with the inverse cell-interleaver permutation. Although important for a correct operation, this aspect is not directly relevant to the invention.

Fig. 3C shows a block diagram of a transmitter for rotated constellations according to a third embodiment of the present invention. The block diagram is similar to the block diagram of Fig. 3B, wherein like reference numerals denote like components, a repetition of the detailed explanation of which is omitted.

As it is apparent from Fig. 3C, an alternative transmitter block diagram with identical functionality can be obtained by moving the cell interleaver 180 and the component deinterleaver 165 to a position upstream of the QAM mapper 120, so that they are applied to bits instead of complex symbols. Such a configuration may be more efficient for a hardware implementation.

Fig. 3D shows a block diagram of a transmitter for rotated constellations according to a fourth embodiment of the present invention, which is a combination of the second and the third embodiment described above. The block diagram is similar to the block diagram of Fig. 3C, wherein like reference numerals denote like components, a repetition of the detailed explanation of which is omitted.

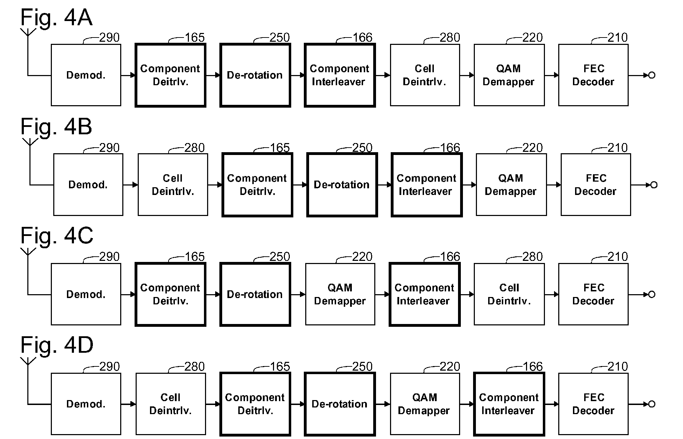

The receiver mirrors the functionality of the transmitter. Block diagrams are shown in Figures 4A-D, which correspond to the transmitter structures of Figures 3A-D according to the first to fourth embodiment of the present invention, respectively.

The received signal is first processed in order by a radio-frequency RF frontend (not shown), typically comprising a tuner and a down-converter, then by a demodulator 290, which produces complex symbols at its output.

In order to achieve good performance when decoding rotated constellations, it is necessary to perform the de-rotation and the QAM demapping jointly. This is possible only for the receiver structures in Figure 4C and Figure 4D, as no blocks must come between the de-rotation block 250 and the QAM demapper 220, so that the two blocks can be merged.

The QAM demapper 220 extracts B*D bits from each D-dimensional constellation block. The extracted bits that are part of the same FEC block are then interleaved using a component interleaver 166 matched to the preceding component deinterleaver 165, deinterleaved using a cell deinterleaver 280, and decoded with a FEC decoder 210.

Summarizing, the present invention relates to communication systems that employ rotated constellations and provides a transmitter in which a component interleaver is paired with a matching deinterleaver upstream of the constellation rotation, as well as corresponding receivers and methods. According to this configuration, component separation can be performed while preserving the cell order.

## Claims

1. A method for transmitting digital data, said method comprising the steps of:
encoding (110) a block of data with a forward error correction code;
mapping (120) the encoded block of data to a sequence of real-valued symbols;
applying (165) a first symbol permutation to the sequence of real-valued symbols;
dividing the permuted sequence of real-valued symbols into a plurality of *D-*dimensional vectors and transforming (150) each of the *D*-dimensional vectors by multiplying the vector with an orthogonal matrix, resulting in a sequence of transformed symbols;
applying (166) a second symbol permutation to the sequence of transformed symbols, wherein the first symbol permutation is an inverse of the second symbol permutation;
mapping (180) the transformed symbols of the permuted sequence of transformed symbols to a sequence of complex symbols; and
transmitting (190) the sequence of complex symbols.

2. A method according to claim 1, wherein the second symbol permutation is adapted such that the D real-valued symbols of each transformed vector are mapped to D distinct complex symbols of the sequence of complex symbols.

3. A method according to claim 1 or 2, wherein the second symbol permutation is adapted such that the D real-valued symbols of each transformed vector are essentially evenly distributed over the sequence of transformed symbols.

4. A method according to any of claims 1 to 3, wherein the forward error correction code is a turbo code, a low-density parity-check code or a quasi-cyclic low-density parity-check code.

5. A method according to any of claims 1 to 4, wherein D equals 2 or 4 or 8.

6. A method according to any of claims 1 to 5, wherein the mapping (180) of the transformed symbols of the permuted sequence of transformed symbols to the sequence of complex symbols is performed by mapping two consecutive transformed symbols of the permuted sequence of transformed symbols to one complex symbol of the sequence of complex symbols.

7. A method according to claim 6, further comprising the step of applying a cell permutation to the sequence of complex symbols.

8. A method according to any of claims 1 to 7, wherein the mapping (120) of the encoded block of data to the sequence of real-valued symbols is performed in accordance with a pulse amplitude modulation scheme or an amplitude shift keying scheme.

9. A method according to any of claims 1 to 8, wherein the mapping (120) of the encoded block of data to the sequence of real-valued symbols is performed such that B consecutive bits of the encoded block of data are mapped to one real-valued symbol of the sequence of real-valued symbols, B being a positive integer, preferably B=1, 2, 3, or 4.

10. An apparatus for transmitting digital data, said apparatus comprising:
an encoder (110) for encoding a block of data with a forward error correction code;
a mapper (120) for mapping the encoded block of data to a sequence of real-valued symbols;
a component deinterleaver (165) for applying a first symbol permutation to the sequence of real-valued symbols;
a rotation unit (150) for dividing the permuted sequence of real-valued symbols into a plurality of D-dimensional vectors and transforming each of the D-dimensional vectors by multiplying the vector with an orthogonal matrix, resulting in a sequence of transformed symbols;
a component interleaver (166) for applying a second symbol permutation to the sequence of transformed symbols, wherein the first symbol permutation is an inverse of the second symbol permutation;
a cell interleaver (180) for mapping the transformed symbols of the permuted sequence of transformed symbols to a sequence of complex symbols; and
a modulator (190) for transmitting the sequence of complex symbols.

11. A method for receiving digital data, said method comprising the steps of:
receiving (290) a sequence of complex symbols;
mapping (280) the a sequence of complex symbols to a sequence of real-valued symbols;
applying (165) a first symbol permutation to the sequence of real-valued symbols;
dividing the permuted sequence of real-valued symbols into a plurality of *D-*dimensional vectors and transforming (250) each of the *D*-dimensional vectors by multiplying the vector with an orthogonal matrix, resulting in a sequence of transformed symbols;
applying (166) a second symbol permutation to the sequence of transformed symbols, wherein the first symbol permutation is an inverse of the second symbol permutation;
de-mapping (120) the sequence of real-valued symbols to an encoded block of data; and
decoding (210) the encoded block of data with a forward error correction code.

12. A method according to claim 11, wherein the forward error correction code is a turbo code, a low-density parity-check code or a quasi-cyclic low-density parity-check code.

13. A method according to claims 11 or 12, wherein D equals 2 or 4 or 8.

14. An apparatus for receiving digital data, said apparatus comprising:
a demodulator (290) for receiving a sequence of complex symbols;
a cell deinterleaver (280) for mapping the sequence of complex symbols to a sequence of real-valued symbols;
a component deinterleaver (165) for applying a first symbol permutation to the sequence of real-valued symbols;
a de-rotation unit (250) for dividing the permuted sequence of real-valued symbols into a plurality of *D*-dimensional vectors and for transforming each of the *D*-dimensional vectors by multiplying the vector with an orthogonal matrix, resulting in a sequence of transformed symbols;
a component interleaver (166) for applying a second symbol permutation to the sequence of transformed symbols, wherein the first symbol permutation is an inverse of the second symbol permutation;
a de-mapper (120) for de-mapping the sequence of real-valued symbols to an encoded block of data; and
a decoder (210) for decoding the encoded block of data with a forward error correction code.
